# EUROPÄISCHE PATENTANMELDUNG

(11) **EP 1 146 557 A2**
(43) Veröffentlichungstag der Anmeldung: **17.10.2001**
(21) Anmeldenummer: 01106756.8
(22) Anmeldetag: 17.03.2001
(51) Int. Cl.: H01L 21/8242

(54) **Grabenkondensator sowie dazugehöriges Herstellungsverfahren**

(30) Priorität: 12.04.2000 DE 10019090
(71) Anmelder: Infineon Technologies AG, 81669 München (DE)
(72) Erfinder: Schrems, Martin, Dr., 01465 Langebrück (DE)
(74) Vertreter: Kindermann, Peter, Dipl.-Ing.

(57) **Zusammenfassung**

Die vorliegende Erfindung betrifft einen Grabenkondensator (160) sowie ein dazugehöriges Herstellungsverfahren, wobei ein Isolationskragen (168) derart nicht konform im oberen Bereich eines Grabens (108) ausgebildet ist, dass eine Schichtdicke (dₒ) in einem oberen Abschnitt des Isolationskragens (168) größer ist als eine Schichtdicke (dᵤ) in einem unteren Abschnitt des Isolationskragens. Dadurch erhält man einen Grabenkondensator (160) mit verbesserten Leckstromeigenschaften sowie einen vereinfachten sowie kostengünstigen Prozess zum Ausbilden des Isolationskragens (168).

## Beschreibung

Die vorliegende Erfindung bezieht sich auf einen Grabenkondensator sowie ein dazugehöriges Herstellungsverfahren und insbesondere auf einen Grabenkondensator mit verbesserten Leckstromeigenschaften sowie ein dazugehöriges Herstellungsverfahren mit vereinfachten Prozessschritten zum Ausbilden eines Isolationskragens bzw. Collars.

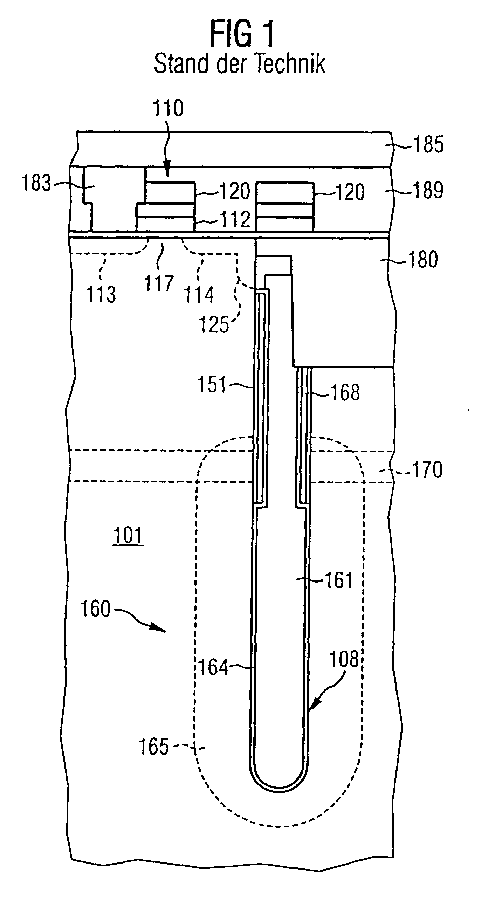

Figur 1 zeigt eine vereinfachte Schnittansicht einer DRAM-Halbleiter-Speicherzelle mit Grabenkondensator gemäß dem Stand der Technik, wie sie beispielsweise aus der Druckschrift EP 0 949 680 A2 bekannt ist. Gemäß Figur 1 besitzt eine herkömmliche DRAM-Halbleiter-Speicherzelle einen Grabenkondensator 160, der in einem Substrat 101 ausgebildet ist. Der Grabenkondensator 160 besteht im Wesentlichen aus einem Graben 108, der mit einem leitenden Füllmaterial 161 als zweiter Kondensatorplatte aufgefüllt wird. In der Umgebung eines unteren Bereichs des Grabens 108 ist im Substrat 101 als erste Kondensatorplatte eine vergrabene Platte 165 ausgebildet, die beispielsweise durch eine Diffusion aus einer ASG-Schicht ausgebildet werden kann. Zwischen der als erste Kondensatorplatte dienenden vergrabenen Platte 165 und dem als zweite Kondensatorplatte dienenden Füllmaterial 161 befindet sich eine dielektrische Schicht 164 zur Verkleidung des unteren Bereichs des Grabens 108 und zur Ausbildung eines Kondensatordielektrikums.

Ferner besitzt die DRAM-Halbleiter-Speicherzelle einen Feldeffekttransistor 110, der ein Gate 112 sowie Source- und Drain-Diffusionsgebiete 113 und 114 aufweist. Die Diffusionsgebiete 113 und 114 sind von einem Kanal 117 voneinander getrennt, wobei das Diffusionsgebiet 114 über ein Kontaktgebiet 125 mit dem Grabenkondensator 160 in Verbindung steht.

Zur Vermeidung von unerwünschten Leckströmen befindet sich an einem oberen Bereich des Grabenkondensators 160 bzw. des Grabens 108 ein Isolationskragen bzw. Collar 168.

Eine vergrabene Wanne bzw. Schicht 170 befindet sich unterhalb der Oberfläche des Substrats 101 und dient im Wesentlichen als Verbindung zwischen den vergrabenen Platten 165 der jeweiligen benachbarten DRAM-Halbleiter-Speicherzellen im Speicherzellenfeld.

Zum Ansteuern der jeweiligen DRAM-Halbleiter-Speicherzellen bzw. des Speicherfeldes besitzt jede Zelle eine Bitleitung sowie eine Wortleitung. Üblicherweise bilden die Gates 112 eine Wortleitung, während das Diffusionsgebiet 113 über einen Kontakt 183 mit einer Bitleitung 185 verbunden ist. Die Bitleitung 185 ist hierbei vom Diffusionsgebiet durch eine Isolierschicht 189 getrennt.

Gemäß Figur 1 sind jeweils benachbarte DRAM-Halbleiter-Speicherzellen durch eine flache Grabenisolation (STI, shallow trench isolation) voneinander getrennt, wobei eine Wortleitung 120 nicht nur über dem eigentlichen Transistor 110, sondern auch über dem Graben 108 liegt, wodurch man eine sogenannte gefaltete Bitline-Architektur erhält. Die nachfolgend beschriebene Erfindung ist jedoch nicht auf eine derartige Architektur beschränkt.

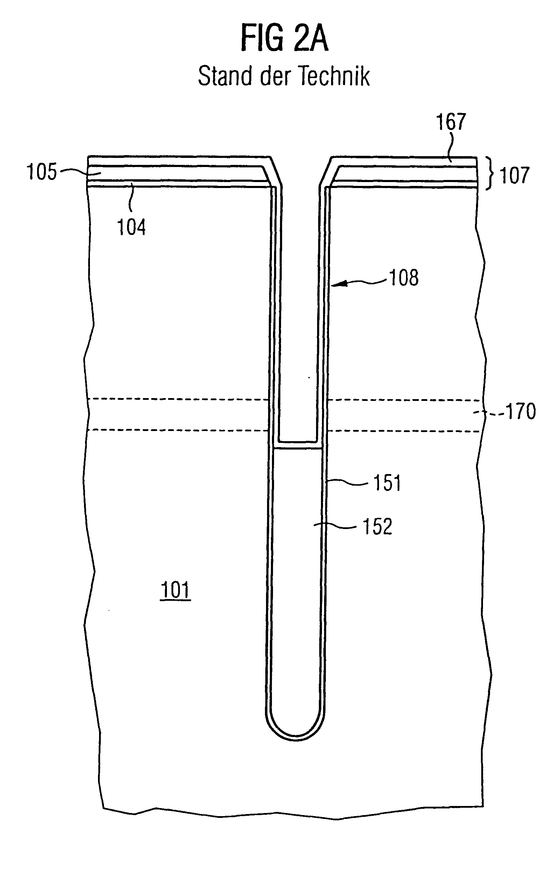

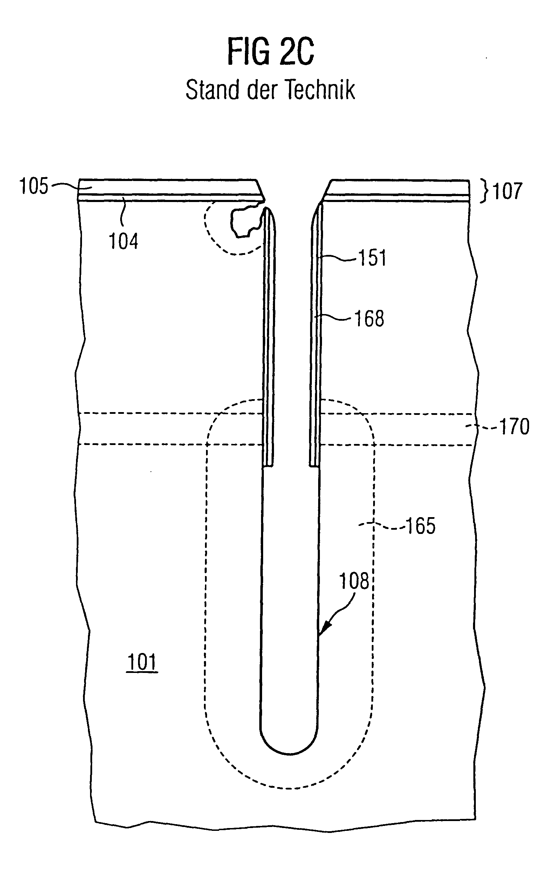

Figuren 2A bis 2C zeigen wesentliche Verfahrensschritte zum Ausbilden des Isolationskragens 168 gemäß dem Stand der Technik, wobei gleiche Bezugszeichen gleiche oder ähnliche Elemente bzw. Schichten bezeichnen und nachfolgend auf eine detaillierte Beschreibung verzichtet wird.

Gemäß Figur 2A wird zunächst unter Zuhilfenahme eines sogenannten Pad-Stapels 107 der Graben 108 im Halbleiter-Substrat 101 ausgebildet. Der Pad-Stapel 107 besteht beispielsweise aus einer Pad-Oxidschicht 104 und einer Pad-Stoppschicht 105, der eine nicht dargestellte Hartmaskenschicht überlagert werden kann. Eine als Ätzstoppschicht oder Barrierenschicht dienende Oxidschicht (SiO₂) bzw. Grenzschicht 151 ist vorzugsweise 5 bis 50 nm dick und kann durch Abscheidung oder thermisch ausgebildet werden. Auf eine detaillierte Beschreibung des Verfahrens zum Ausbilden des Pad-Stapels 107 bzw. des Grabens 108 wird an dieser Stelle verzichtet, da es im Wesentlichen einem herkömmlichen Verfahren entspricht.

Ferner wird gemäß Figur 2A in einem unteren Bereich des Grabens 108 ein Opfer-Füllmaterial 152 ausgebildet, welches beispielsweise aus Polysilizium besteht. Anschließend wird eine koplanare Isolationskragenschicht 167 an der Oberfläche des Wafers bzw. im Graben 108 ausgebildet. Diese konforme Isolationskragenschicht 167 bzw. Collarschicht wird beispielsweise durch ein chemisches Abscheideverfahren (CVD, chemical vapor deposition) ausgebildet, wobei vorzugsweise ein Oxid mit einer konstanten Dicke von ca. 2 bis 10 nm abgeschieden wird. Anschließend wird zur Verbesserung der Eigenschaften der Isolationskragenschicht 167 eine Verdichtung durchgeführt, die beispielsweise bei einer Temperatur von ca. 1000 Grad Celsius in einer N₂- oder Ar-Umgebung stattfindet.

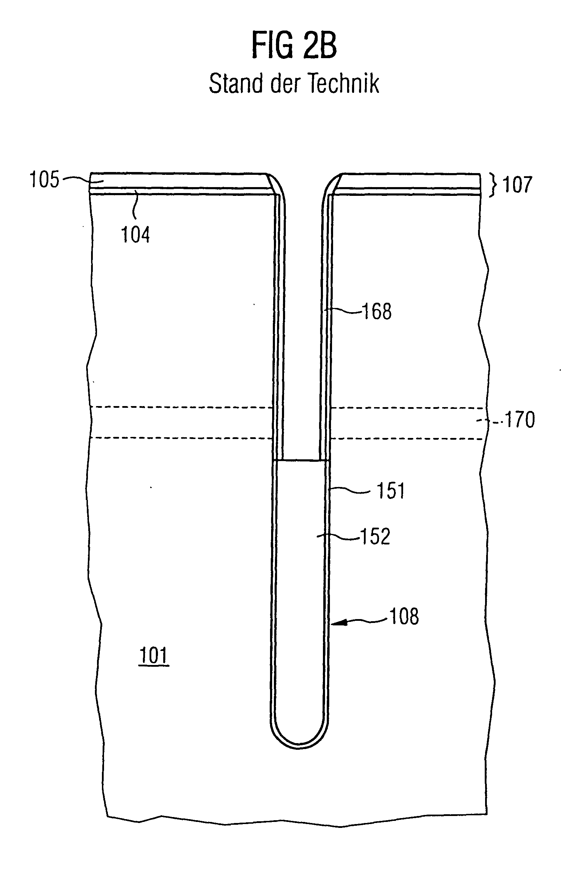

Gemäß Figur 2B findet in einem anschließenden Verfahrensschritt eine Strukturierung der Isolationskragenschicht 167 bzw. des Collars statt, wobei vorzugsweise ein reaktives Ionenätzen (RIE) mit beispielsweise CF₄, CHF₃ oder C₄F₈ durchgeführt wird. Gemäß Figur 2B verbleibt nach diesem Strukturierungsschritt auf dem Pad-Stapel 107 keine Isolationskragenschicht 167 zurück, wodurch im Wesentlichen der Isolationskragen 168 ausgebildet wird. Gleichzeitig wird bei diesem Verfahrensschritt das Opfer-Füllmaterial 152 im Graben 108 freigelegt, um somit ein Entfernen dieses Opfer-Füllmaterials 152 zu ermöglichen.

Gemäß Figur 2C wird in einem nachfolgenden Verfahrensschritt das Opfer-Füllmaterial 152 und die Grenzschicht 151 vollständig im unteren Bereich des Grabens 108 entfernt (insbesondere, wenn als Grenzschicht 151 ein thermisches Oxid (SiO₂) und/oder ein abgeschiedenes Oxid verwendet wird, so kann sie als Barrierenschicht im oberen Bereich des Grabens 108 erhalten bleiben), wobei sich auch eine Rückätzung des Isolationskragens 168 in seinem oberen Bereich ergeben kann. Im ungünstigsten Fall wird bei einem derartigen Verfahrensschritt der Isolationskragen 168 an seiner Oberseite derart weit zurückgeätzt, dass das Halbleiter-Substrat 101 freigelegt wird und eine Ätzung des Substrats 101 in einem oberen Bereich des Grabens 108 erfolgt. Die Wahrscheinlichkeit für ein derartiges unerwünschtes Freilegen des Substrats 101 erhöht sich noch, wenn beispielsweise eine Grabenerweiterung im unteren Bereich des Grabens 108 durchgeführt wird. Eine Funktion der DRAM-Halbleiter-Speicherzelle wird dadurch wesentlich beeinträchtigt bzw. vollständig verhindert. Ferner kann bei Verwendung einer Gasphasendotierung zum Ausbilden der vergrabenen Platte 165 bei der freigelegten Siliziumkante ebenso eine Gebiet mit hoher Dotierung unerwünschterweise ausgebildet werden, wodurch wiederum die Funktion der Halbleiter-Speicherzelle leidet.

Da beim vorstehend beschrieben Verfahren die Isolationskragenschicht 167 vollständig vom Pad-Stapel 107 entfernt wird, wird bei einem nachfolgend durchgeführten Überätzen zur Sicherstellung einer ausreichenden Öffnung zum Opfer-Füllmaterial 152 ein Teil des Pad-Stapels 107 abgetragen. Ein derartiger Abtrag des Pad-Nitrids bzw. des Pad-Stapels 107 im Zellenfeld und in (nicht dargestellten) planaren Supportgebieten erfolgt ungleichförmig, weshalb eine Planarisierung insbesondere der flachen Grabenisolierung (STI) in nachfolgenden Prozessschritten erschwert wird. Darüber hinaus ist für die flache Grabenisolation bzw. das STI-Oxid 180 eine vorbestimmte Mindestdicke des Pad-Stapels bzw. der Pad-Nitridschicht als Ätzstoppschicht erforderlich, so dass man üblicherweise eine um die Abtragsdicke erhöhte Anfangsdicke des Pad-Stapels bzw. Pad-Nitrids benötigt. Diese erhöhte Pad-Stapeldicke erfordert wiederum einen längeren Maskenöffnungsprozess für den Graben 108 (deep trench mask open process), welcher mehr Resist verbraucht, wodurch eine dickere Resist-Schicht erforderlich wird. Eine dickere Resist-Schicht verschlechtert jedoch wiederum das Prozessfenster der Grabenlithographie, was zu einer verringerten Ausbeute führen kann.

Darüber hinaus kann bei nachfolgenden Ätzprozessen ebenfalls der Pad-Stapel 107 abgetragen werden, was wiederum zu Ausbeuteverlusten führen kann. Ferner kann bei einer Facettierung der Stoppschicht bzw. Pad-Nitridschicht 105 (stark getaperte Pad-Nitridschicht 105 am Rande des Grabens) das Substrat oberhalb der oberen Isolationskragenkante freigelegt werden. Eine derartige Pad-Nitrid-Facettierung entsteht üblicherweise während eines Graben-Ätzprozesses, wobei die Selektivität des Graben-Ätzprozesses zur Hartmaske zum Rand einer Wafer-Scheibe hin abnimmt. Daher kann es beim Graben-Ätzprozess für Gräben am Scheibenrand zu einem völligen Abtrag der Hartmaske, die das Pad-Nitrid 105 vor einem Ätzangriff schützen soll, kommen, wodurch sogenanntes "Pad-Nitrid-Facetting" entsteht. Im Extremfall kann die Pad-Nitridschicht 105 im Bereich um die Gräben am Scheibenrand völlig abgetragen werden (nicht dargestellt), so dass eine vollständige Freilegung der Siliziumoberkante erfolgt. Dies kann zu einer Zerstörung der Grabenstrukturen in der Nähe der Oberfläche führen, wodurch Siliziumpartikel entstehen, die wiederum bei nachfolgenden Nassreinigungen über die gesamte Wafer-Scheibe verteilt werden und zu massiven Ausbeuteverlusten führen.

Der Erfindung liegt daher die Aufgabe zu Grunde, einen Grabenkondensator mit verbessertem Leckstromverhalten und ein dazugehöriges Herstellungsverfahren mit verbesserter Ausbeute sowie einem vereinfachten und kostengünstigen Isolationskragenprozess zu schaffen.

Erfindungsgemäß wird diese Aufgabe hinsichtlich des Grabenkondensators durch die Merkmale des Patentanspruchs 1 und hinsichtlich des Herstellungsverfahrens durch die Maßnahmen der Patentansprüche 7, 10 und 15 gelöst.

Insbesondere durch die Verwendung eines nicht konformen Isolationskragens, der in einem oberen Abschnitt des Grabens eine größere Schichtdicke aufweist als in einem unteren Abschnitt des Grabens, erhält man bei vereinfachter Prozessführung ein verbessertes Leckstromverhalten sowie eine erhöhte Ausbeute.

Vorzugsweise ist der Isolationskragen im Wesentlichen dreiecksförmig ausgebildet und kann aus einer oder einer Vielzahl von Schichten bestehen. Im Falle eines Isolationskragens aus mehreren Schichten kann eine Schicht als (Opfer-) Schutzschicht gegenüber nachfolgenden Ätzprozessen dienen.

Beim Ausbilden des Isolationskragens wird vorzugsweise ein Ausbilden einer nicht konformen Isolationskragenschicht und ein anschließendes Entfernen von zumindest einem Teil der nicht konformen Isolationskragenschicht durchgeführt. Auf diese Weise kann zuverlässig eine vorstehend beschriebene Pad-Nitrid-Facettierung am Rande der Gräben mit der damit einhergehenden Substratabtragung verhindert werden. Insbesondere bei Entfernen von zumindest einem Teil der nicht konformen Isolationskragenschicht mittels isotropen oder anisotropen Ätzens erhält man eine wesentliche Vereinfachung bei der Ausbildung des Isolationskragens und der vergrabenen Platte im Grabenkondensator.

Alternativ kann eine konforme Isolationskragenschicht mit einer überlagerten nicht konformen (Opfer-) Schutzschicht ausgebildet werden, wodurch insbesondere bei flaschenförmigen Grabenkondensatorstrukturen ein Frei- bzw. Anätzen von Hohlräumen zuverlässig verhindert wird.

Vorzugsweise wird für das Ausbilden der nicht konformen Isolationskragenschicht ein chemisches Abscheideverfahren (CVD), ein Plasmaabscheideverfahren (PECVD, plasma enhanced CVD) oder ein chemisches Niederdruck-Abscheideverfahren (LPCVD) verwendet, welches ohnehin in Standardprozessen zur Verfügung steht. Sowohl die Herstellungskosten als auch die Zuverlässigkeit des Grabenkondensators lassen sich dadurch wesentlich verbessern.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:
- Figur 1: eine vereinfachte Schnittansicht einer Halbleiter-Speicherzelle mit Grabenkondensator gemäß dem Stand der Technik;
- Figur 2A bis 2C: Verfahrensschritte zum Ausbilden eines Isolationskragens im Grabenkondensator gemäß dem Stand der Technik;
- Figur 3: eine vereinfachte Schnittansicht einer Halbleiter-Speicherzelle mit Grabenkondensator gemäß einem ersten Ausführungsbeispiel;
- Figur 4: eine vereinfachte Schnittansicht des Grabenkondensators gemäß dem ersten Ausführungsbeispiel zur Veranschaulichung einer ersten Ausführungsform zur Herstellung des Isolationskragens;
- Figur 5: eine vereinfachte Schnittansicht des Grabenkondensators gemäß dem ersten Ausführungsbeispiel zur Veranschaulichung einer zweiten Ausführungsform zur Herstellung eines Isolationskragens;
- Figur 6: eine vereinfachte Schnittansicht des Grabenkondensators gemäß dem ersten Ausführungsbeispiel zur Veranschaulichung einer dritten Ausführungsform zur Herstellung eines Isolationskragens;
- Figur 7: eine vereinfachte Schnittansicht eines Grabenkondensators gemäß einem zweiten Ausführungsbeispiel zur Veranschaulichung einer weiteren Ausführungsform zur Herstellung eines Isolationskragens; und
- Figur 8: eine vereinfachte Schnittansicht einer Halbleiter-Speicherzelle mit Grabenkondensator gemäß einem dritten Ausführungsbeispiel;
- Figuren 9A bis 9C: vereinfachte Schnittansichten eines Grabenkondensators gemäß einem vierten Ausführungsbeispiel zur Veranschaulichung einer ersten Ausführungsform zur Herstellung eines Isolationskragens; und
- Figur 10: eine vereinfachte Schnittansicht eines Grabenkondensators gemäß dem vierten Ausführungsbeispiel zur Veranschaulichung einer zweiten Ausführungsform zur Herstellung eines Isolationskragens.

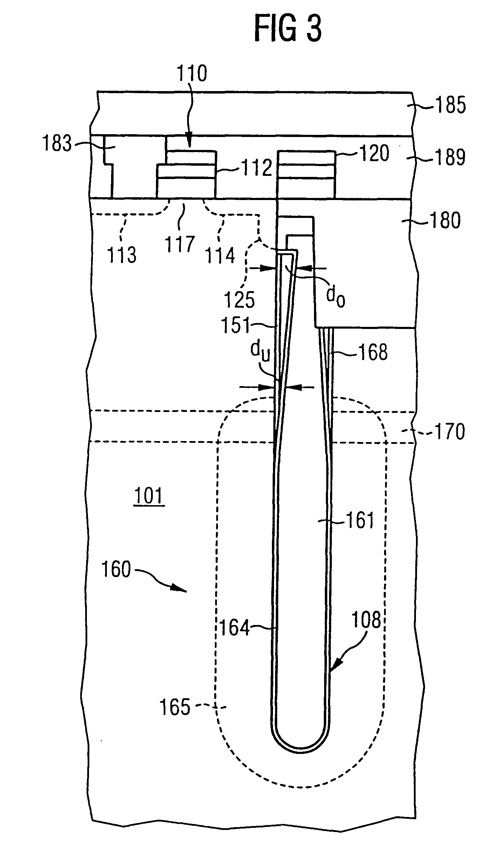

Figur 3 zeigt eine vereinfachte Schnittansicht einer Halbleiter-Speicherzelle gemäß einem ersten Ausführungsbeispiel der vorliegenden Erfindung, wobei gleiche Bezugszeichen gleiche oder ähnliche Elemente bzw. Schichten bezeichnen und zur Vermeidung von Wiederholungen nachfolgend auf ihre detaillierte Beschreibung verzichtet wird.

Der wesentliche Unterschied zwischen der Halbleiter-Speicherzelle mit Grabenkondensator gemäß dem ersten Ausführungsbeispiel zur herkömmlichen Halbleiter-Speicherzelle gemäß Figur 1 besteht darin, dass der Isolationskragen 168 nicht konform ausgebildet ist. Genauer gesagt ist eine Schichtdicke dₒ in einem oberen Abschnitt des Isolationskragens 168 größer als eine Schichtdicke dᵤ in einem unteren Abschnitt des Isolationskragens 168. Auf diese Weise erhält man für den Grabenkondensator 160 weiter verbesserte Leckeigenschaften, da eine elektrische Isolierung vom Kontaktgebiet 125 zur vergrabenen Platte 165 weiter verbessert ist.

Gemäß Figur 3 ist der Querschnitt des Isolationskragens 168 im Wesentlichen dreiecksförmig und verjüngt sich in Richtung zum unteren Bereich des Grabens 108. Der nicht konforme Isolationskragen 168 kann hierbei aus einer einzigen Schicht wie z. B. einer Oxidschicht, einer Nitridschicht oder einer Oxinitrid-Schicht bestehen, wobei jedoch auch Mehrschichtstrukturen für den nicht konformen Isolationskragen denkbar und günstig sind und der Isolationskragen 168 aus einer Vielzahl von vorzugsweise Oxid-, Nitrid- und/oder Oxinitrid-Schichten bestehen kann. Neben dem verbesserten Leckstromverhalten besteht jedoch ein wesentlicher Vorteil des nicht konformen Isolationskragens in der Vereinfachung eines Herstellungsprozesses für den Grabenkondensator 160, wie nachfolgend im Einzelnen beschrieben wird.

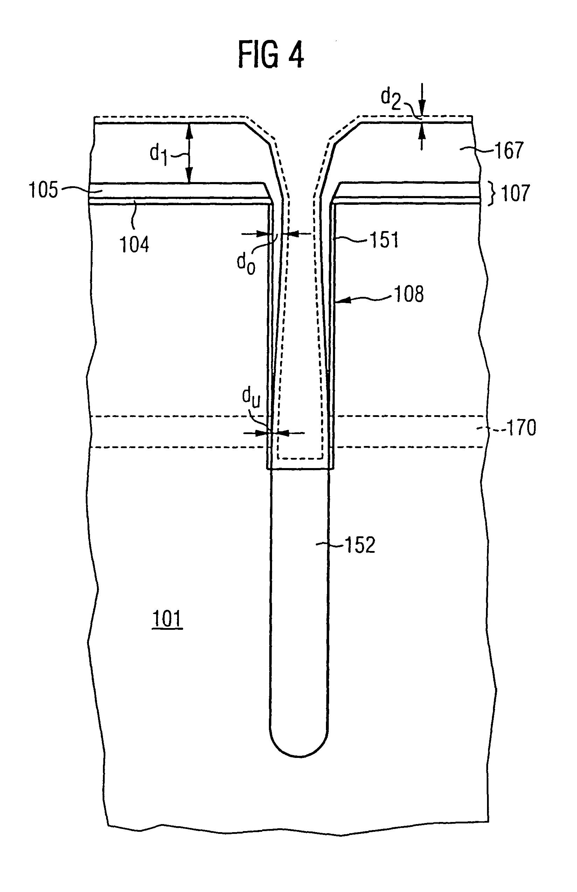

Figur 4 zeigt eine vereinfachte Schnittansicht des Grabenkondensators zur Veranschaulichung einer ersten Ausführungsform zur Herstellung des Isolationskragens 168. Die Figur 4 entspricht hierbei im Wesentlichen den herkömmlichen Verfahrensschritten gemäß Figuren 2A bis 2C, weshalb auf eine detailliert Beschreibung der Elemente und Schichten mit gleichen Bezugszeichen nachfolgend verzichtet wird.

Gemäß Figur 4 wird im Gegensatz zum herkömmlichen Verfahren eine nicht konforme Isolationskragenschicht 167 abgeschieden und anschließend durch ein isotropes Ätzen gleichmäßig abgetragen. Die gestrichelte Linie stellt hierbei eine ursprüngliche Dicke bzw. Form der Isolationskragenschicht 167 nach einem Ausbildeschritt dar, während die durchgezogene Linie den verbleibenden Teil der Isolationskragenschicht nach Entfernen bzw. dem isotropen Ätzen einer Teiloberfläche der nicht konformen Isolationskragenschicht 167 darstellt.

Gemäß Figur 4 wird demzufolge zunächst ein Graben 108 im Substrat 101 ausgebildet und nach Ausbilden der Grenzschicht 151 ein Opfer-Füllmaterial 152 eingebracht und bis zu einem unteren Bereich des Grabens 108 eingesenkt. Anschließend erfolgt eine nicht konforme Abscheidung der Isolationskragenschicht 167 auf dem Pad-Stapel 107, der im Wesentlichen aus einer Pad-Oxidschicht 104 und einer Pad-Nitridschicht 105 besteht.

Zur Realisierung der nicht konformen Isolationskragenschichtabscheidung wird beispielsweise ein chemisches Abscheideverfahren (CVD, chemical vapor deposition) mit einer SiH₄ + O₂ Abscheidung bei ca. 450 Grad Celsius und einem reduzierten Druck von einigen 100 Torr durchgeführt. Alternativ kann jedoch auch ein chemisches Niederdruck-Abscheideverfahren (LPCVD, low pressure chemical vapor deposition) durchgeführt werden, bei dem eine TEOS-Abscheidung bei ca. 600 bis 800 Grad Celsius und einem Druck von beispielsweise 0,05 bis 0,5 Torr durchgeführt wird. Auch ein Plasmaabscheideverfahren (PECVD, plasma enhanced CVD) ermöglicht eine nicht konforme Abscheidung von Schichten und insbesondere der Isolationskragenschicht.

Gemäß Figur 4 ergibt sich somit eine nicht konforme Isolationskragenschicht 167, deren Dicke d₁ außerhalb des Grabens 108 wesentlich größer ist als innerhalb des Grabens und die innerhalb des Grabens 108 im Wesentlichen dreiecksförmig (dₒ > dᵤ) ausgebildet ist. Nach Ausbildung der nicht konformen Isolationskragenschicht 167 kann beispielsweise eine thermische Oxidation und/oder eine Verdichtung durchgeführt werden, die beispielsweise bei einer Temperatur von 900 Grad Celsius in einer Umgebung von O₂ oder einer Temperatur von ca. 1000 Grad Celsius in einer Umgebung von N₂ für ca. eine Stunde durchgeführt wird.

Anschließend wird durch eine isotropes Ätzen die ursprüngliche Isolationskragenschicht 167 (gestrichelte Linie) gleichförmig bzw. konform um eine Dicke d₂ < 20 nm zurückgeätzt, wodurch sich die eigentliche Isolationskragenschicht 167 ergibt (durchgezogene Linie). Gemäß Figur 4 wird somit das Opfer-Füllmaterial 152 zuverlässig freigelegt, während der obere Kantenbereich des Grabens 108 mit einer ausreichend dicken Isolationskragenschicht 167 bedeckt bleibt. Eine thermisch ausgebildete und/oder abgeschiedene Grenzschicht 151 befindet sich zunächst sowohl im unteren als auch oberen Bereich des Grabens 108 und ermöglicht somit ein zuverlässiges Entfernen des Opfer-Füllmaterials 152 ohne Anätzung des Substrats 101. Anschließend wird diese Grenzschicht 151 im unteren Bereich des Grabens 108 selektiv entfernt. Ein unkontrolliertes Aushöhlen des Substrats 101, wie es beispielsweise in Figur 2C dargestellt ist, kann auf diese Weise für nachfolgende Ätzschritte zuverlässig verhindert werden. Beispielsweise können dies Ätzschritte zum Aufweiten des Grabens 108 selektiv zur Isolationskragenschicht 167 (z.B. nasschemisches Ätzen mit NH4OH oder KOH) sein.

Vorzugsweise wird das nachfolgende Ausbilden der vergrabenen Platte 165 durch Ausdiffusion aus dem Opfer-Füllmaterial 152 durchgeführt. Alternativ kann jedoch auch eine Gasphasendotierung durchgeführt werden, wobei die Isolationskragenschicht 167 als Diffusionsbarriere wirkt. Zur Verbesserung einer derartigen Barrierewirkung kann die Isolationskragenschicht 167 jedoch auch aus einer Vielzahl von Schichten bestehen, wobei zumindest eine dieser Schichten als bevorzugte Diffusionsbarriere wirkt. Die unterhalb des Opfer-Füllmaterials 152 an den Grabenwänden des Grabens 108 als Ätzstoppschicht ausgebildete Grenzschicht 151 wird vorzugsweise mittels eines LPCVD- oder CVD-Verfahrens mit einer Dicke von 5 bis 50nm ausgebildet, sie kann jedoch auch eine native oder thermisch ausgebildete Oxidschicht (Sio2) aufweisen. Ein Entfernen des Opfer-Füllmaterials 152 kann dadurch wesentlich vereinfacht werden.

In gleicher Weise kann jedoch eine derartige Ätzstoppschicht als Dotierstoffquelle zum Ausbilden der vergrabenen Platte 165 vorgesehen werden, wobei vorzugsweise eine ASG-Schicht verwendet wird (Arsensilikatglas). In diesem Fall wird jedoch eine derartige Barrierenschicht nicht in einem oberen Bereich des Graben 108 ausgebildet. Zur Verbesserung der elektrischen Eigenschaften des Isolationskragens 168 wird dieser üblicherweise mittels eines thermischen Verfahrens verdichtet. Ein derartiger Verdichtungsvorgang wird vorzugsweise gleichzeitig mit dem Ausdiffundieren aus der Ätzstoppschicht oder beim Ausbilden der Isolationskragenschicht 167 und dem Ausdiffundieren aus der Ätzstoppschicht durchgeführt. Auf die verschiedensten Möglichkeiten zum Ausbilden des Grabens 108 und der vergrabenen Platte 165 wird nachfolgend nicht weiter eingegangen und vielmehr auf die verschiedenen Verfahren hingewiesen, wie sie in herkömmlichen Verfahren angewendet werden. In diesem Zusammenhang wird insbesondere auf die bekannten Verfahren der Druckschrift EP 0 949 680 A2 hingewiesen.

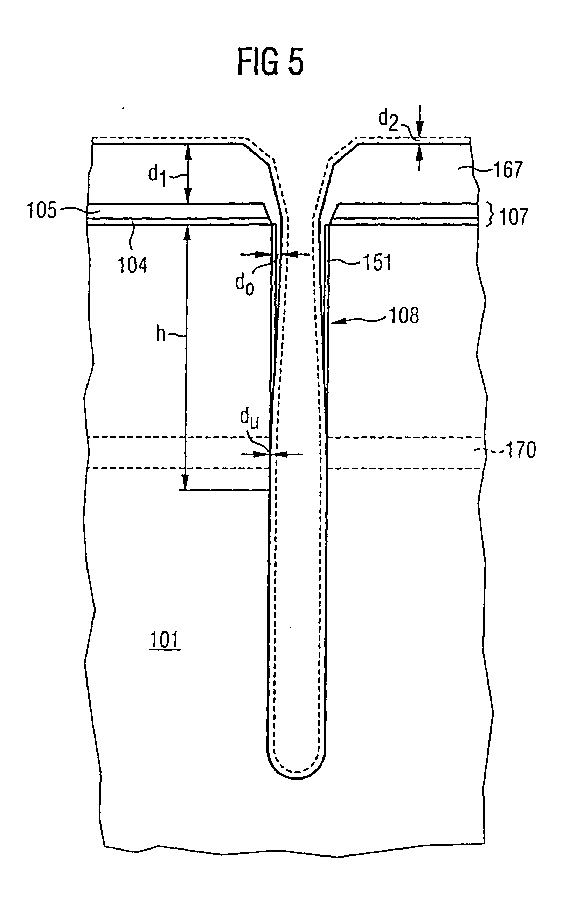

Figur 5 zeigt eine vereinfachte Schnittansicht eines Grabenkondensators gemäß dem ersten Ausführungsbeispiel zur Veranschaulichung einer zweiten Ausführungsform zur Herstellung des Isolationskragens 168.

Im Gegensatz zur Ausführungsform gemäß Figur 4 wird in Figur 5 kein Opfer-Füllmaterial 152 verwendet, sondern die nicht konforme Isolationskragenschicht 167 vollständig im Graben 108 ausgebildet. Das Ausbilden der nicht konformen Isolationskragenschicht 167 erfolgt hierbei in gleicher Weise wie bei Figur 4. Nach einem isotropen Ätzen der Isolationskragenschicht 167 verbleibt wiederum nur in einem oberen Bereich des Grabens 108 ein nicht konformer Isolationskragen 168, der einen ausreichenden Schutz des Pad-Stapels 107 gewährleistet. Eine Höhe h des Isolationskragens 168 ergibt sich hierbei im Wesentlichen aus der nicht konformen Abscheidung der Isolationskragenschicht 167 und dem isotropen Ätzprozess zum Entfernen einer obersten Schicht der Isolationskragenschicht 167.

Vorzugsweise wird das isotrope Ätzen derart eingestellt, dass die abgetragene Schichtdicke d₂ der Isolationskragenschicht 167 < 20 nm ist und die verbleibende Schichtdicke d₁ der Isolationskragenschicht an der Oberfläche des Wafers ca. 80 nm beträgt. In einem oberen Abschnitt des Grabens 108 beträgt die Isolationskragenschicht 167 bzw. der Isolationskragen vorzugsweise eine Dicke dₒ von 40 nm.

Die zweite Ausführungsform gemäß Figur 5 ist insbesondere für eine Gasphasendotierung geeignet, wobei der Isolationskragen 168 bzw. die Isolationskragenschicht 167 als Diffusionsbarriere wirkt. Wiederum kann hierbei die Isolationskragenschicht 167 aus einer Vielzahl von Schichten bestehen, wodurch sich eine Diffusionsbarrierenwirkung und eine Ätzstoppwirkung weiter verbessern lassen.

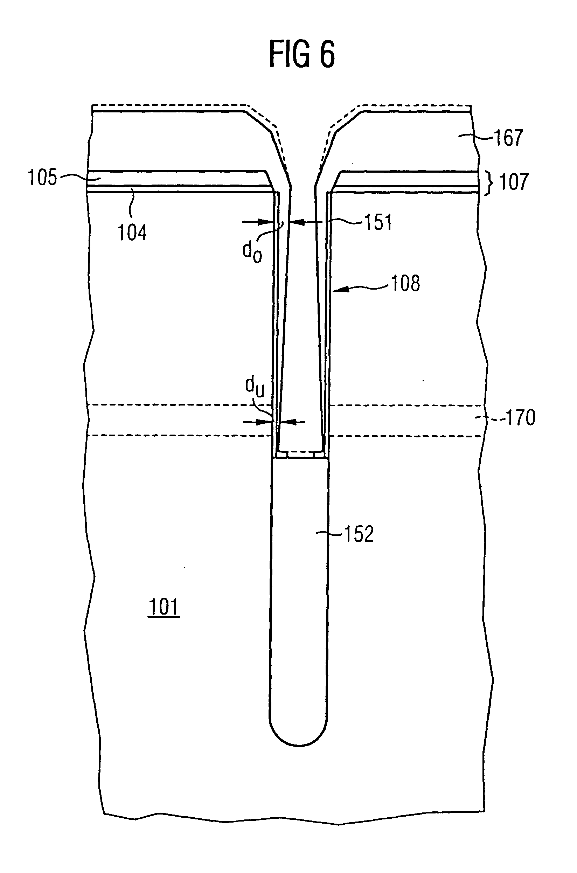

Figur 6 zeigt eine vereinfachte Schnittansicht eines Grabenkondensators gemäß dem ersten Ausführungsbeispiel zur Veranschaulichung einer dritten Ausführungsform zur Herstellung des Isolationskragens. Gleiche Bezugszeichen bezeichnen wiederum gleiche oder ähnliche Elemente bzw. Schichten, weshalb nachfolgend auf ihre detaillierte Beschreibung verzichtet wird.

Die Ausführungsform gemäß Figur 6 entspricht im Wesentlichen der Ausführungsform gemäß Figur 4, wobei wiederum ein Opfer-Füllmaterial 152 im unteren Bereich des Grabens 108 verwendet wird. Gemäß Figur 6 wird jedoch an Stelle des isotropen, d.h. ungerichteten, Ätzens ein anisotropes, d.h. gerichtetes, Ätzen verwendet, wodurch lediglich die gestrichelte Oberflächenschicht der Isolationskragenschicht 167 entfernt wird. Während beim isotropen Ätzen ein gleichförmiges Abtragen der Isolationskragenschicht sowohl außerhalb als auch innerhalb des Grabens 108 durchgeführt wird, erfolgt bei dem in Figur 6 dargestellten anisotropen Ätzen, wie es beispielsweise durch ein reaktives Ionenätzen (RIE) durchgeführt werden kann, eine Abtragung der Isolationskragenschicht 167 lediglich an deren horizontalen Oberflächen, d.h. an der Oberfläche außerhalb des Grabens 108 und am Bodenbereich des Grabens 108. Da die planare Dicke der Isolationskragenschicht 167 auf dem Pad-Stapel 107 größer ist als im Graben, ist die Isolationskragenschicht innerhalb des Grabens 108 bereits geöffnet, bevor die Isolationskragenschicht auf dem Pad-Stapel 107 vollständig abgetragen ist.

Auf diese Weise erhält man wiederum eine ausreichend dicke Schutzschicht oberhalb des Pad-Stapels 107, wodurch eine Abtragung des Substrats an den Grabenoberkanten bzw. eine Zerstörung von Gräben in Wafer-Außenbereichen zuverlässig verhindert werden kann. Die Ausbeute wird somit wiederum beträchtlich erhöht, wobei ferner wesentlich geringere Strukturbreiten realisiert werden können. Das Ausbilden der vergrabenen Platte 165 erfolgt wiederum wie in der ersten Ausführungsform gemäß Figur 4.

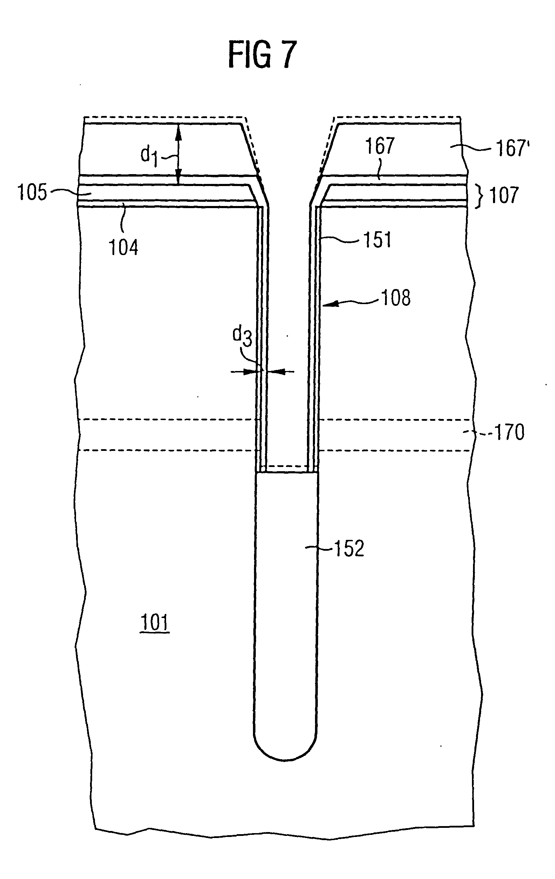

Figur 7 zeigt eine vereinfachte Schnittansicht eines Grabenkondensators gemäß einem zweiten Ausführungsbeispiel der vorliegenden Erfindung, wobei gleiche Bezugszeichen gleiche oder ähnliche Elemente bzw. Schichten bezeichnen und auf eine wiederholte Beschreibung nachfolgend verzichtet wird.

Gemäß Figur 7 besitzt der Grabenkondensator gemäß dem zweiten Ausführungsbeispiel einen konformen Isolationskragen, d.h. einen Isolationskragen 168 mit gleichbleibender Schichtdicke. Wiederum wird jedoch eine nicht konforme Isolationskragenschicht 167 und 167' an der Oberfläche des Wafers ausgebildet. Eine Dicke d₁ der Isolationskragenschicht 167 und 167' an der Oberfläche des Wafers bzw. außerhalb des Grabens 108 ist hierbei wesentlich größer als eine vertikale Schichtdicke d₃ der Isolationskragenschicht 167 und 167' innerhalb des Grabens 108 und einer horizontalen Schichtdicke die nachfolgend geöffnet werden soll.

Vorzugsweise wird eine derartige nicht konforme Isolationskragenschicht 167 und 167' wiederum durch das in Figur 4 beschriebenen Abscheideverfahren ausgebildet. Gemäß Figur 7 kann die Isolationskragenschicht jedoch auch aus einer Doppelschicht oder Mehrschichtenstruktur bestehen, wobei zumindest eine erste Isolationskragenschicht 167 konform ausgebildet ist und eine zweite Isolationskragenschicht 167' nicht konform vorzugsweise außerhalb des Grabens 108 ausgebildet wird.

Beim Ausführungsbeispiel gemäß Figur 7 ist lediglich ein anisotropes Ätzen zum Entfernen von zumindest einem Teil der Isolationskragenschicht möglich, da die Isolationskragenschicht im Seitenwandbereich und im Bodenbereich des Grabens 108 eine gleiche Dicke d₃ aufweist. Das in Figur 7 dargestellte Verfahren ist daher vorzugsweise in Verbindung mit einem Opfer-Füllmaterial 152 zu verwenden.

Das Ausbilden der vergrabenen Platte 165 sowie die sonstigen Modifikationsmöglichkeiten entsprechen wiederum den Möglichkeiten im ersten Ausführungsbeispiel.

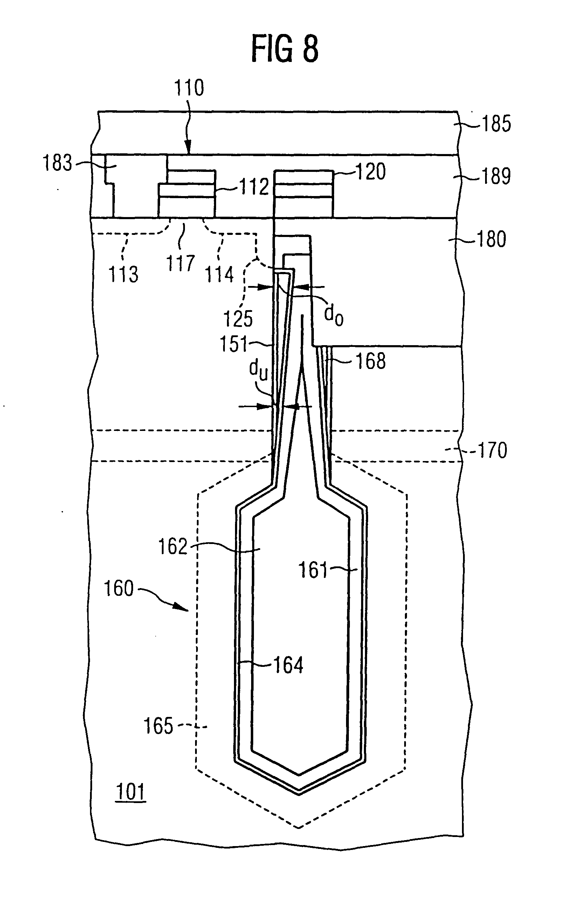

Figur 8 zeigt eine vereinfachte Schnittansicht einer Halbleiter-Speicherzelle mit erweitertem Grabenkondensator gemäß einem dritten Ausführungsbeispiel, wobei gleiche Bezugszeichen gleiche oder ähnliche Schichten bzw. Elemente wie in Figur 1 bezeichnen und zur Vermeidung von Wiederholungen nachfolgend auf ihre Beschreibung verzichtet wird.

Der wesentliche Unterschied des Grabenkondensators 160 gemäß dem dritten Ausführungsbeispiel besteht im Gegensatz zum Grabenkondensator des vorstehend beschriebenen ersten und zweiten Ausführungsbeispiels darin, dass der untere Bereich des Grabens 108 gegenüber dem oberen Bereich zum Bilden einer Flaschenform aufgeweitet bzw. erweitert ist. Eine derartige Erweiterung erhält man beispielsweise nach Entfernung des Opfer-Füllmaterials 152 und der Grenzschicht 151 durch ein isotropes Ätzen, wobei selektiv zur verbliebenen Isolationskragenschicht 167 das Substrat 101 im unteren Bereich des Grabens 108 abgetragen wird.

Eine derartige Vergrößerung des Grabens 108 dient insbesondere der Kapazitätssteigerung, wodurch sich wiederum kleinere Strukturgrößen bzw. eine weitergehende Integration realisieren lässt. Durch die Erweiterung des Grabenkondensators 160 entsteht im unteren Bereich des Grabens 108 ein Hohlraum 162, der im Wesentlichen durch das leitende Füllmaterial 161 umgeben wird. Wiederum ergibt sich auch jedoch hier durch die nicht konforme Abscheidung der Isolationskragenschicht 167 ein verbesserter Schutz für den Pad-Stapel 107, wodurch sich eine vereinfachte Herstellung eines Isolationskragens 168 bei verbesserter Ausbeute realisieren lässt.

Wiederum kann die Ausbildung des Isolationskragens gleichzeitig mit dessen Verdichtung durchgeführt werden. Für die Erweiterung des Grabens im unteren Bereich kann beispielsweise ein NH₄OH-Nassätzverfahren, ein KOH-Nassätzverfahren oder ein isotropes Trockenätzverfahren verwendet werden.

Für das Rückätzen der Isolationskragenschicht 167 und/oder das Entfernen der Grenzschicht 151 kann bei den vorstehend beschriebenen Ausführungsbeispielen entweder ein isotropes Nassätzen, wie z.B. DHF oder BHF, oder ein isotropes Trockenätzen, wie z.B. CF₄/O₂, verwendet werden. Als anisotropes Ätzverfahren zum Abtragen der Isolationskragenschicht wird vorzugsweise ein reaktives Ionenätzen verwendet (RIE), z.B. CF4 oder C4F8.

Zum Ausbilden der vergrabenen Platte 165 wird bei den vorstehend beschriebenen Ausführungsbeispielen vorzugsweise eine Gasphasendotierung mittels AsH₃ oder PH₃ bei einer Temperatur von 900 bis 1000 Grad Celsius durchgeführt. In gleicher Weise kann jedoch auch eine Dotierung aus einer ASG- oder PSG-(Phosphorsilikatglas) Schicht im Graben 108 erfolgen.

Vorzugsweise besteht die Isolationskragenschicht 167 und 167' aus Siliziumoxid, Siliziumnitrid oder einem Oxinitrid. Sie kann jedoch auch aus einem anderen Material bestehen und insbesondere eine Mehrschichtstruktur aufweisen, wobei eine Schicht als Schutzschicht gegenüber einem Ätzen oder einer Diffusion wirkt.

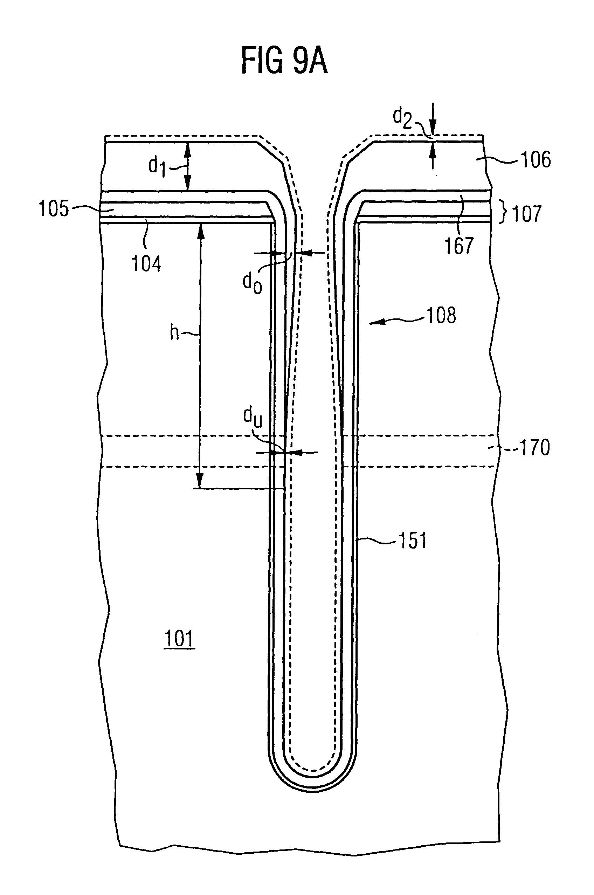

Figuren 9A bis 9C zeigen vereinfachte Schnittansichten einer ersten Ausführungsform eines Grabenkondensators gemäß einem vierten Ausführungsbeispiel der vorliegenden Erfindung, wobei gleiche Bezugszeichen gleiche oder ähnliche Elemente bzw. Schichten bezeichnen und auf eine wiederholte Beschreibung nachfolgend verzichtet wird.

Gemäß Figur 9A wird zunächst der Graben 108 im Substrat 101 ausgebildet und anschließend eine konforme Isolationskragenschicht 167 an den Seitenwänden abgeschieden und/oder thermisch ausgebildet. Vorzugsweise wird die Isolationskragenschicht 167 als SiO₂-Schicht mit einer Dicke von ca. 5-50nm mittels eines CVD- oder LPCVD-Verfahrens im Graben abgeschieden. Zur Verbesserung der Leckstromeigenschaften der Isolationskragenschicht 167 kann beispielsweise durch thermische Oxidation eine sogenannte Durchoxidation zum Ausbilden einer Grenzschicht 151 (thermisches Oxid) durchgeführt werden.

Anschließend wird in einem weiteren Verfahrensschritt eine nicht konforme Opfer-Schutzschicht 106 derart im Graben 108 und an der Oberfläche des Wafers ausgebildet, dass die planaren Gebiete sowie zumindest der obere Bereich des Grabens 108 mit einer dickeren Schicht bedeckt sind. Vorzugsweise wird die Opfer-Schutzschicht 106 als Si₃N₄-Schicht mittels eines PECVD oder LPCVD-Verfahrens abgeschieden. Es kann jedoch auch Si oder ein sonstiges Material als Opfer-Schutzschicht 106 nicht konform abgeschieden werden. Gemäß Figur 9A besitzt demzufolge die Isolationskragenschicht eine konstante Dicke, während die darüber liegende Opfer-Schutzschicht die Schichtdicken d1 > do > du im planaren Bereich des Wafers sowie im oberen und unteren Bereich des Grabens 108 aufweist.

In einem nachfolgenden Verfahrensschritt kann beispielsweise eine isotrope Rückätzung der Opfer-Schutzschicht 106 (gestrichelte Linie) erfolgen, wodurch die Isolationskragenschicht 167 bis zu einer Höhe h freigelegt wird. Die Opfer-Schutzschicht 106 (durchgezogene Linie) kann jedoch auch derart nicht konform im Graben ausgebildet werden, dass sie im unteren Bereich des Grabens 108 die Isolationskragenschicht 167 erst gar nicht bedeckt und somit die isotrope Rückätzung entfallen kann.

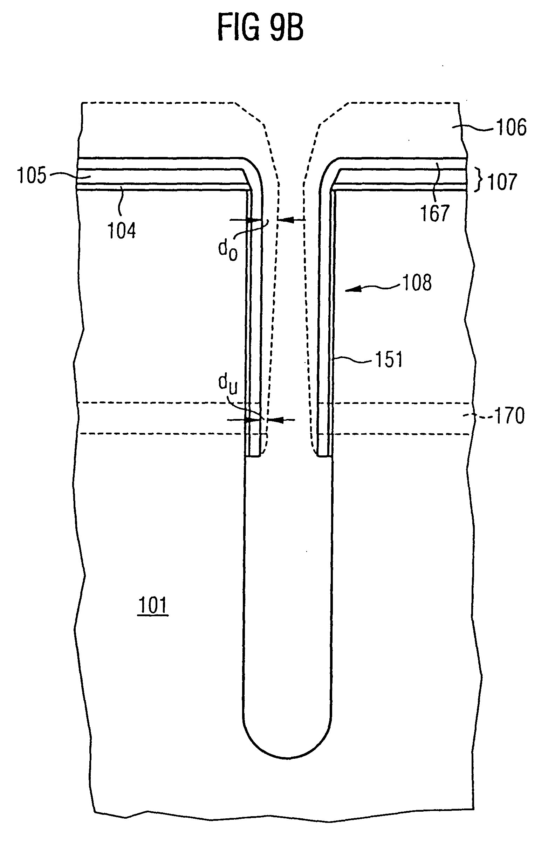

Gemäß Figur 9B wird in einem nachfolgenden Verfahrensschritt unter Verwendung der Opfer-Schutzschicht 106 als Maske der untere Bereich der Isolationskragenschicht entfernt. Vorzugsweise wird für dieses Entfernen der Isolationskragenschicht selektiv zur Opfer-Schutzschicht 106 ein nasschemisches (z.B. BHF) oder ein trockenchemisches Ätzverfahren verwendet. Nach dem Entfernen des unteren Bereichs der Isolationskragenschicht wird in einem nachfolgenden Verfahrensschritt die noch verbleibende Opfer-Schutzschicht 106 vollständig entfernt, wobei vorzugsweise nasschemische oder isotrope trockenchemische Verfahren (z.B. HF/EG oder H₃PO₄ im Falle einer Nitrid-Opfer-Schutzschicht) verwendet werden.

In nicht dargestellten Verfahrensschritten kann (optional) nachfolgend der untere Bereich des Grabens 108 selektiv zur Isolationskragenschicht 167 aufgeweitet werden, wodurch man wiederum eine Flaschenform erhält. Für das Aufweiten des unteren Bereichs des Grabens wird vorzugsweise ein nasschemisches Ätzverfahren mittels NH₄OH oder KOH verwendet.

Anschließend erfolgt wiederum das Ausbilden der vergrabenen Platte 165 selektiv zur Isolationskragenschicht 167, wobei vorzugsweise eine Gasphasendotierung mit AsH₃ bei einer Temperatur von 900°C eingesetzt wird. Alternativ kann eine ASG-oder PSG-Abscheidung erfolgen, wobei ein Eintreiben (Drive-In) der Dotierstoffe während einer anschließenden Temperung erfolgt. Daraufhin wird die ASG- oder PSG-Schicht wieder entfernt und nachfolgend wird wiederum eine dielektrische Schicht 164 ausgebildet, wobei neben Nitrid/Oxid auch dielektrische Materialien mit einer hohen relativen Dielektrizitätskonstante (z.B. Al₂O₃, TiOₓ, ...) und auch eine Kombination mit geeigneten Metallelektroden (SIS, semiconductor-insulator-semiconductor; MIS, metal-insulator-semiconductor; MIM, metal-insulator-metal) möglich ist. Abschließend wird der Graben 108 mit einem leitenden Füllmaterial 161 aufgefüllt, welches als Gegenelektrode zur vergrabenen Platte 165 dient.

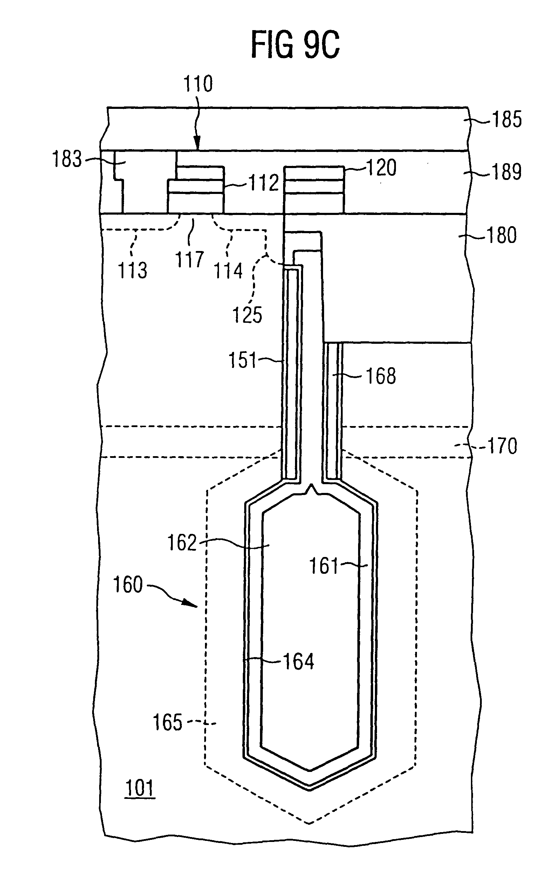

Figur 9C zeigt eine vereinfachte Schnittansicht einer Halbleiter-Speicherzelle mit erweitertem Grabenkondensator wie sie durch die vorstehenden Verfahrensschritte ausgebildet wird. Der besondere Vorteil bei Verwendung der vorstehenden Verfahrensschritte liegt im Gegensatz zu dem in Figur 8 dargestellten Ausführungsbeispiel vor allem darin, dass die Verfahrensschritte zum Ausbilden des Opfer-Füllmaterials 152 (z.B. Auffüllen und Einsenken) sowie die Schritte zum Entfernen (z.B. Ätzen) des Opfer-Füllmaterials 152 sowie von Teilen der Isolationskragenschicht 167 entfallen. Die Herstellung wird dadurch weiter vereinfacht.

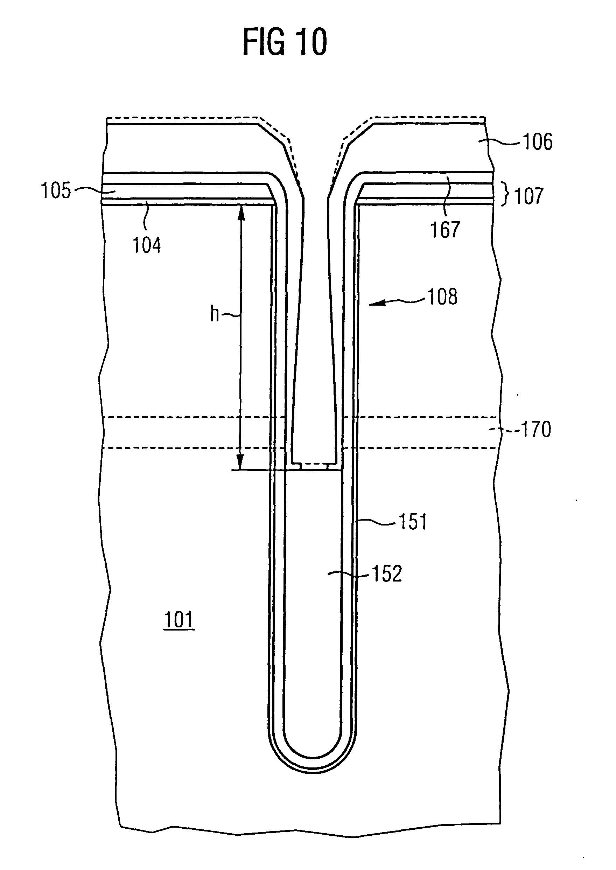

Figur 10 zeigt eine vereinfachte Schnittansicht einer zweiten Ausführungsform eines Grabenkondensators gemäß dem vierten Ausführungsbeispiel der vorliegenden Erfindung, wie sie in einem bevorzugten Herstellungsverfahren verwendet wird. Gleiche Bezugszeichen bezeichnen gleiche oder ähnliche Elemente bzw. Schichten wie in Figuren 9A bis 9C, weshalb auf eine wiederholte Beschreibung nachfolgend verzichtet wird.

Gemäß der in Figur 10 dargestellten zweiten Ausführungsform des vierten Ausführungsbeispiels der vorliegenden Erfindung können auch die nachfolgend beschriebenen Verfahrensschritte zur Herstellung der in Figur 9C dargestellten Halbleiter-Speicherzelle mit Grabenkondensator verwendet werden. Hierbei wird zunächst der Graben 108 im Substrat 101 ausgebildet. Anschließend erfolgt wiederum die konforme Ausbildung bzw. Abscheidung der Isolationskragenschicht 167 im Graben 108. In einem nachfolgenden Schritt wird jedoch nunmehr ein Opfer-Füllmaterial 152 im Graben 108 ausgebildet und bis zu einer Tiefe h eingesenkt. In einem nachfolgenden Verfahrensschritt wird daraufhin die Opfer-Schutzschicht 106 nicht konform im Graben 108 ausgebildet und in einem unteren Bereich durch ein anisotropes Ätzverfahren zum Opfer-Füllmaterial hin geöffnet (gestrichelte Linie). Beispielsweise wird hierbei ein reaktives Ionenätzen (RIE) mit CF4 verwendet.

Nunmehr kann das Opfer-Füllmaterial 152 selektiv zur Opfer-Schutzschicht 106 und zur Isolationskragenschicht 167 entfernt werden. Nachfolgend wird selektiv zur im oberen Grabenbereich verbleibenden Opfer-Schutzschicht 106 die Isolationskragenschicht 167 im unteren Bereich des Grabens 108 entfernt. Beispielsweise wird hierbei eine BHF-Nassätzung verwendet, wobei die Opfer-Schutzschicht z.B. Si₃N₄ aufweist.

Optional kann anschließend wiederum eine Aufweitung des Grabens 108 unterhalb der verbleibenden Isolationskragenschicht 167 erfolgen. Die Ausbildung der vergrabenen Platte 165 erfolgt nachfolgend beispielsweise mittels Gasphasendotierung. Nachfolgend kann die Opfer-Schutzschicht 106 nasschemisch (z.B. mit HF/EG oder H₃PO₄) oder trockenchemisch entfernt werden. Anschließend wird wiederum die dielektrische Schicht 164 und das leitende Füllmaterial 161 im Graben ausgebildet, wodurch man wiederum einen Grabenkondensator bzw. eine Halbleiter-Speicherzelle gemäß Figur 9C erhält. Da lediglich die Opfer-Schutzschicht nicht konform ausgebildet wird, erhält man auf diese Weise aufgrund des konformen Isolationskragens 168 ein verbessertes Füllverhalten für die dielektrische Schicht 164 und insbesondere für das leitende Füllmaterial 161, wodurch sich die Eigenschaften des Grabenkondensators weiter verbessern.

Die vorliegende Erfindung wurde vorstehend anhand einer DRAM-Halbleiter-Speicherzelle beschrieben. Sie ist jedoch nicht darauf beschränkt und umfasst vielmehr alle weiteren integrierten Schaltungen in denen ein Grabenkondensator verwendet werden kann, wie z.B. Speichervorrichtungen mit wahlfreiem Speicherzugriff (RAM), synchrone dynamische Speicher mit wahlfreiem Zugriff (SDRAM), statische Speicher mit wahlfreiem Zugriff (SRAM), Nur-Lesespeicher (ROM) sowie programmierbare Logikfelder (PLA), anwenderspezifische Schaltungen (ASIC) und eingebettete Logik-Speicherschaltungen.

## Patentansprüche

1. Grabenkondensator mit
einem Graben (108), der in einem Substrat (101) ausgebildet ist;
einem Isolationskragen (168), der in einem oberen Bereich des Grabens (108) ausgebildet ist;
einer vergrabenen Platte (165), die in der Umgebung eines unteren Bereichs des Grabens (108) im Substrat (101) als erste Kondensatorplatte ausgebildet ist;
einer dielektrischen Schicht (164) zur Verkleidung des unteren Bereichs des Grabens (108) und des Isolationskragens (168) als Kondensatordielektrikum; und
einem in den Graben (108) gefüllten leitenden Füllmaterial (161) als zweite Kondensatorplatte,
**dadurch gekennzeichnet, dass** der Isolationskragen (168) derart nicht konform im oberen Bereich des Grabens (108) ausgebildet ist, dass eine Schichtdicke dₒ in einem oberen Abschnitt des Isolationskragens größer ist als eine Schichtdicke (dᵤ) in einem unteren Abschnitt.

2. Grabenkondensator nach Patentanspruch 1,
**dadurch gekennzeichnet, dass** ein Querschnitt des Isolationskragens (168) im Wesentlichen dreiecksförmig ist.

3. Grabenkondensator nach Patentanspruch 1 oder 2,
**dadurch gekennzeichnet, dass** der Isolationskragen (168) eine Vielzahl von Schichten (167, 167') aufweist.

4. Grabenkondensator nach Patentanspruch 3,
**dadurch gekennzeichnet, dass** zumindest eine der Vielzahl von Schichten (167, 167') des Isolationskragens (168) nicht konform ausgebildet ist.

5. Grabenkondensator nach einem der Patentansprüche 1 bis 4,
**dadurch gekennzeichnet, dass** der Graben (108) eine Flaschenform aufweist und im verbreiterten Bereich des leitenden Füllmaterials (161) ein Hohlraum (162) ausgebildet ist.

6. Grabenkondensator nach einem der Patentansprüche 1 bis 5,
**dadurch gekennzeichnet, dass** der Isolationskragen (168) aus einem Oxid, einem Nitrid und/oder einem Oxynitrid besteht.

7. Verfahren zur Herstellung eines Grabenkondensators mit den Schritten:
Ausbilden eines Grabens (108) in einem Substrat (101);
Ausbilden eines Opfer-Füllmaterials (152) in einem unteren Bereich des Grabens (108);
Ausbilden einer nicht konformen Schicht (167, 167') im aufgefüllten Graben;
Entfernen von zumindest einem Teil der nicht konformen Schicht (167, 167') zum Freilegen des Opfer-Füllmaterials (152);
Entfernen des Opfer-Füllmaterials (152) aus dem unteren Bereich des Grabens (108);
Ausbilden einer vergrabenen Platte (165) im Substrat (101) in der Umgebung des unteren Bereichs des Grabens (108) als erste Kondensatorplatte;
Ausbilden einer dielektrischen Schicht (164) zur Verkleidung des unteren Bereichs des Grabens (108) und einer Innenseite des Isolationskragens (168) als Kondensatordielektrikum; und
Füllen des Grabens (108) mit einem leitenden Füllmaterial (161) als zweite Kondensatorplatte.

8. Verfahren nach Patentanspruch 7,
**gekennzeichnet durch** die weiteren Schritte:
Ausbilden einer Grenzschicht (151) an den Grabenwänden nach Ausbildung des Grabens (108); und
Entfernen der Grenzschicht (151) im unteren Bereich des Grabens (108) nach Entfernung des Opfer-Füllmaterials (152).

9. Verfahren nach Patentanspruch 7 oder 8,
**dadurch gekennzeichnet, dass** beim Ausbilden des Opfer-Füllmaterials (152)
ein Füllen des Grabens (108) mit Opfer-Füllmaterial und
ein Einsenken des Opfer-Füllmaterials (152) bis zu einer vorbestimmten Höhe (h) durchgeführt wird.

10. Verfahren zur Herstellung eines Grabenkondensators mit den Schritten:
Ausbilden eines Grabens (108) in einem Substrat (101);
Ausbilden einer nicht konformen Schicht (167, 167'; 106) im Graben (108);
Entfernen von zumindest einem Teil der nicht konformen Schicht (167, 167'; 106) im unteren Bereich des Grabens (108);
Ausbilden einer vergrabenen Platte (165) im Substrat (101) in der Umgebung des unteren Bereichs des Grabens (108) als erste Kondensatorplatte;
Ausbilden einer dielektrischen Schicht (164) zur Verkleidung des unteren Bereichs des Grabens (108) und der Innenseite des Isolationskragens (168) als Kondensatordielektrikum; und
Füllen des Grabens (108) mit einem leitenden Füllmaterial (161) als zweite Kondensatorplatte.

11. Verfahren nach einem der Patentansprüche 7 bis 10,
**dadurch gekennzeichnet, dass** beim Ausbilden der nicht konformen Schicht (167)
eine konforme Isolationskragenschicht mit einer ersten Dicke (d₁) außerhalb des Grabens (108) und
eine konforme Isolationskragenschicht mit einer zweiten Dicke (d₃) innerhalb des Grabens (108) ausgebildet ist.

12. Verfahren nach einem der Patentansprüche 7 bis 10,
**dadurch gekennzeichnet, dass** beim Ausbilden der nicht konformen Schicht (167) eine konforme Isolationskragenschicht mit einer ersten Dicke (d₁) außerhalb des Grabens (108) und
eine nicht konforme Isolationskragenschicht (167) mit unterschiedlichen Dicken (dₒ bis dᵤ) innerhalb des Grabens (108) ausgebildet ist.

13. Verfahren nach einem der Patentansprüche 7 bis 10,
**dadurch gekennzeichnet, dass** beim Ausbilden der nicht konformen Schicht
eine konforme Isolationskragenschicht (167) innerhalb und außerhalb des Grabens (108) und
eine nicht konforme Opfer-Schutzschicht (106) mit unterschiedlichen Dicken (dᵤ, dₒ) zumindest innerhalb des Grabens (108) ausgebildet ist.

14. Verfahren nach einem der Patentansprüche 11 bis 13,
**dadurch gekennzeichnet, dass** beim Ausbilden der nicht konformen Isolationskragenschicht eine Vielzahl von Schichten (167, 167') ausgebildet werden.

15. Verfahren zur Herstellung eines Grabenkondensators mit den Schritten:
Ausbilden eines Grabens (108) in einem Substrat (101);
Ausbilden einer konformen Isolationskragenschicht (167) im Graben (108);
Ausbilden eines Opfer-Füllmaterials (152) in einem unteren Bereich des Grabens (108);
Ausbilden einer nicht konformen Opfer-Schutzschicht (106) im oberen Bereich des Grabens;
Entfernen von zumindest einem Teil der nicht konformen Opfer-Schutzschicht (106) zum Freilegen des Opfer-Füllmaterials (152);
Entfernen des Opfer-Füllmaterials (152) aus dem unteren Bereich des Grabens (108);
Entfernen der Isolationskragenschicht (167) im unteren Bereich des Grabens (108);
Ausbilden einer vergrabenen Platte (165) im Substrat (101) in der Umgebung des unteren Bereichs des Grabens (108) als erste Kondensatorplatte;
Ausbilden einer dielektrischen Schicht (164) zur Verkleidung des unteren Bereichs des Grabens (108) und der Innenseite des Isolationskragens (168) als Kondensatordielektrikum; und
Füllen des Grabens (108) mit einem leitenden Füllmaterial (161) als zweite Kondensatorplatte.

16. Verfahren nach Patentanspruch 15,
**dadurch gekennzeichnet, dass** beim Ausbilden des Opfer-Füllmaterials (152)
ein Füllen des Grabens (108) mit Opfer-Füllmaterial und
ein Einsenken des Opfer-Füllmaterials (152) bis zu einer vorbestimmten Höhe (h) durchgeführt wird.

17. Verfahren nach einem der Patentansprüche 7 bis 16,
**dadurch gekennzeichnet, dass** das Ausbilden der nicht konformen Schicht (167) oder Opfer-Schutzschicht (106) mit einem CVD-, PECVD- oder LPCVD-Verfahren erfolgt.

18. Verfahren nach einem der Patentansprüche 7 bis 17,
**dadurch gekennzeichnet, dass** das Entfernen von zumindest einem Teil der nicht konformen Schicht (167) oder Opfer-Schutzschicht (106) mittels isotropen oder anisotropen Ätzens erfolgt.

19. Verfahren nach einem der Patentansprüche 7 bis 18,
**dadurch gekennzeichnet, dass** das Ausbilden der vergrabenen Platte (165) selbstjustierend zur Isolationskragenschicht (167) erfolgt.

20. Verfahren nach einem der Patentansprüche 7 bis 19,
**dadurch gekennzeichnet, dass** das Ausbilden der vergrabenen Platte (165) durch Ausdiffusion aus dem Opfer-Füllmaterial (152) erfolgt.

21. Verfahren nach einem der Patentansprüche 7 bis 19,
**dadurch gekennzeichnet, dass** das Ausbilden der vergrabenen Platte (165) durch eine Gasphasendotierung erfolgt.

22. Verfahren nach Patentanspruch 8,
**dadurch gekennzeichnet, dass** das Ausbilden der vergrabenen Platte (165) durch Ausdiffusion aus der Grenzschicht (151) im unteren Bereich des Grabens (108) erfolgt.

23. Verfahren nach Patentanspruch 8,
**dadurch gekennzeichnet, dass** das Ausbilden der vergrabenen Platte (165) durch Ausdiffusion aus der Grenzschicht (151) gleichzeitig mit einem Verdichten der Isolationskragenschicht (167) erfolgt.

24. Verfahren nach Patentanspruch 23,
**dadurch gekennzeichnet, dass** das Ausbilden der vergrabenen Platte (165) durch Ausdiffusion aus der Grenzschicht (151) gleichzeitig mit dem Ausbilden und Verdichten der Isolationskragenschicht (168) durchgeführt wird.

25. Verfahren nach einem der Patentansprüche 7 bis 24,
**gekennzeichnet durch** den weiteren Schritt des Erweiterns des unteren Bereichs des Grabens (108) gegenüber dem oberen Bereich des Grabens (108) zum Bilden einer Flaschenform.
